Europäisches Patentamt

European Patent Office

Office européen des brevets

(19)

(11) Publication number : **0 486 278 A1**

# (12) EUROPEAN PATENT APPLICATION

(21) Application number : 91310472.5

(22) Date of filing : 13.11.91

(51) Int. Cl.$^5$ : **C08F 265/04,** C09D 4/06, C08F 265/06

(30) Priority : 16.11.90 US 614331

(43) Date of publication of application :
20.05.92 Bulletin 92/21

(84) Designated Contracting States :
AT BE CH DE DK ES FR GB GR IT LI LU NL SE

(71) Applicant : **ROHM AND HAAS COMPANY**
**Independence Mall West**
**Philadelphia Pennsylvania 19105 (US)**

(72) Inventor : **Brown, Albert Benner**
**2113 Blackhorse Drive**
**Warrington, Pennsylvania 18979 (US)**

Inventor : **Maurice, Alvin Michael**
**1505 Berkley Way**
**Lansdale, Pennsylvania 19446 (US)**
Inventor : **Schindler, Frederick James**
**327 Skippack Pike**
**Fort Washington, Pennsylvania 19034 (US)**
Inventor : **Wolfersberger, Martha Harbaugh**
**RD1 Box 421**
**Perkasie, Pennsylvania 18944 (US)**

(74) Representative : **Smith, Julian Philip Howard et al**
**Rohm and Haas (UK) Limited, European Operations Patent Dept., Lennig House, 2 Masons Avenue**
**Croydon CR9 3NB (GB)**

(54) Aqueous-based radiation-curable coating composition.

(57) An aqueous-based, UV radiation-curable coating composition containing a latex polymer emulsion and a multifunctional (meth)acrylate, wherein the latex polymer is selected to be greater than about 47 mole % acrylate and to have a glass transition temperature less than about 28°C is described. The selection of composition and glass transition temperature yields a UV-curable coating with superior direct impact properties which are useful for wood coating applications.

EP 0 486 278 A1

This invention relates to an aqueous-based, radiation-curable coating composition. More particularly, the invention relates to an aqueous-based, ultraviolet ("UV") radiation-curable coating composition containing a latex polymer emulsion and a multifunctional acrylate or methacrylate.

There is a need for high performance coatings that can be applied with low levels of polluting solvents. Aqueous-based thermoplastic coatings can be applied with low levels of polluting solvents, but they do not have the heat and chemical resistance required for many applications, especially where parts must be stacked soon after coating and where the substrate cannot be heated to high temperatures. Chemically-cured coatings that give good heat and chemical resistance have problems with pot life and cure speed.

UV-curable coatings offer a solution to the above problems. However, the current coating technology remains costly and difficult to apply thin coatings. Conventional UV-curable coatings must be diluted with solvent so that they may be sprayed.

A number of patents and publications have disclosed aqueous UV-curable compositions formed from latex polymer emulsions and multifunctional compounds. For example, US-A-4,107,013 teaches a latex with a shell of copolymerized difunctional monomers containing unreacted allyl surface groups. US-A-4,925,893 and EP-A-0,232,016 teach auto-oxidative and radiation curable vinylidene chloride/vinyl chloride/2-ethylhexyl acrylate latices having residual unsaturation via the addition of a low reactivity multifunctional compound, such as diallyl phthalate, late in the polymerization. US-A-4,101,493 is directed to an emulsion of a crosslinking type and a process for producing an emulsion of such a type. The emulsion is made up of polymer emulsion of an oil-in-water type and at least one oligoester-(meth)acrylate which has at least two (meth)acrylol groups per molecule, a molecular weight of not more than 1000 per one (meth)acrylol group and a boiling point at atmospheric pressure of at least 200°C.

Other examples of UV-curable compositions are disclosed in Loutz et al. [Organic Coatings, No. 8, pp. 197-209 (1986)] which teach the preparation of emulsion according to a core-shell introduction of the feed pre-emulsion in a 7/3 ratio. The difunctional monomer is contained in the shell pre-emulsion. Also, JP- 63-270702 teaches a photosetting composition containing an aqueous dispersion of a copolymer and a photopolymerizable monomer wherein the copolymer contains at least 10 weight % of a methacrylate type monomer and/or methyl acrylate and the ratio of copolymer to monomer is from 40:60 to 98:2 and the photopolymerizable monomer has a molecular weight of 100-1,000, a solubility parameter of 8-12 and a boiling point of at least 100°C.

Despite numerous prior attempts to make crosslinkable, UV-curable coatings from mixtures of polymer emulsions and multifunctional compounds, such as those in the aforementioned documents, the prior art coatings do not have superior coatings properties, such as for example direct impact strength. As is known in the art, direct impact strength is a particularly important property for coatings on a variety of substrates and composites, including, for example, wood, paints, inks, plastics, fiber, paper, leather and the like.

It is therefore an object of the present invention to provide a coating that does have superior coatings properties, such as for example direct impact strength.

According to the first aspect of the present invention there is provided a composition comprising a latex polymer emulsion and a multifunctional (meth)acrylate, wherein the latex polymer in the emulsion contains greater than about 47 mole percent acrylate and has a glass transition temperature less than about 28°C.

According to the second aspect of the present invention there is provided a method of using a coating composition comprising a latex polymer emulsion and a multifunctional (meth)acrylate, wherein the latex polymer contains greater than about 47 mole percent acrylate and has a glass transition temperature less than about 28°C as a general purpose curable coating.

According to the third aspect of the present invention there is provided a cured polymer coating comprising a latex polymer emulsion and a multifunctional (meth)acrylate, wherein the latex polymer in said emulsion contains greater than about 47 mole percent acrylate and has a glass transition temperature less than about 28C.

The composition of the present invention has excellent coating properties, especially direct impact strength, without sacrificing other coating properties, such as, for example, print resistance, mar resistance and pencil hardness.

None of the prior art teachings indicates or suggests that the selection of the level of the mole percent acrylate and the glass transition temperature of the polymer emulsion are critical for achieving superior coatings properties, such as for example direct impact strength.

"Latex" as used herein refers to a water-insoluble polymer which may be prepared by conventional polymerization techniques such as, for example, by emulsion polymerization.

"Glass transition temperature," or "$T_g$," as used herein means the glass transition temperature of a polymer as calculated by the Fox equation [Bulletin of American Physics Society 1, 3, page 123 (1956)]:

$$\frac{1}{T_g} = \frac{w_1}{T_{g(1)}} + \frac{w_2}{T_{g(2)}}$$

For a copolymer, $w_1$ and $w_2$ refer to the weight fraction of the two comonomers and $T_{g(1)}$ and $T_{g(2)}$ refer to the glass transition temperatures of the two corresponding homopolymers.

As used herein, acrylate and methacrylate are referred to as "(meth)acrylate", acryloyl group and methacryloyl are referred to as "(meth)acryloyl" and acrylic acid and methacrylic acid are referred to as "(meth)acrylic acid".

"Multifunctional (meth)acrylate", as used herein, refers to a material which has at least two (meth)acryloyl functional groups per molecule, a molecular weight of not more than 1000 per functional group and a boiling point of at least 200°C at atmospheric pressure.

Preferably, the latex polymer contains greater than about 50 mole percent acrylate. More preferably, the latex polymer contains greater than about 70 mole percent acrylate and has a glass transition temperature less than about 15°C.

Preferably, the latex polymer comprises monomers selected from the group consisting of acrylic esters, methacrylic esters, acrylic acid, methacrylic acid, itaconic acid, maleic acid, fumaric acid, butadiene, acrylonitrile, ethylene and vinyl acetate.

Advantageously, the latex polymer further comprises styrene, preferably subsituted styrene, at a level of less than about 12% by weight.

Preferably, the latex polymer comprises methyl acrylate.

Preferably, the multifunctional (meth)acrylate is trimethylolpropane triacrylate or trimethylolpropane trimethacrylate.

Advantageously, the weight ratio of latex polymer to multifunctional (meth)acrylate is from about 30:70 to about 95:5, preferably from about 40:60 to about 60:40, more preferably from about 65:35 to about 75:25.

Preferably, the composition further comprises a photoinitiator.

Advantageously, the photoinitiator is present at a level of less than about 0.5 % by weight of nonvolatiles.

Preferably, the photoinitiator is a cleavage-type photoinitiator.

Preferably, the composition further comprises a thermal initiator.

Preferably, the composition further comprises a catalyst for auto-oxidative cure.

The composition may be used as a coating on wood, such as an item of furniture (e.g. cabinet), a wall or a floor. Likewise, the composition may be used as a coating on plastic or a coating on fiber, paper or leather. Also, the composition may be used as a photoresist. Also, the composition may be used in inks, paint or in adhesives.

Preferably, the cured polymer coating is formed by subjecting the coating to a source of ultraviolet radiation.

The present invention therefore relates to an aqueous-based, UV radiation-curable coating composition containing a latex polymer emulsion and a multifunctional (meth)acrylate, where the latex polymer is selected to be greater than about 47 mole percent acrylate and to have a glass transition temperature less than about 28°C.

The selection of composition and glass transition temperature yields a UV-curable coating with superior direct impact properties which are useful for wood coating applications. The present invention allows the application of thin coatings without the use of toxic solvents. It provides the pot life and cure speed of conventional UV curable coatings with the additional advantage of lower cost and optional use of photoinitiator at a level of less than about 0.5% by weight of nonvolatiles.

The UV-curable compositions of the present invention contain a latex polymer emulsion, a multifunctional (meth)acrylate and optionally a photoinitiator.

The latex polymer used in the UV-curable composition is prepared by emulsion polymerization techniques well known in the art. The latex polymer is formed from any monomer or mixture of monomers which yields a water-insoluble latex polymer which is greater than about 47 mole percent acrylate; and has a glass transition temperature of less than about 28°C in the dry state.

The selection of the minimum mole percent acrylate and the maximum glass transition temperature of the latex polymer emulsion is critical to the operation of the invention.

A wide variety of monomers or mixture of monomers can be used to make the latex polymer. For example, acrylic ester monomers, including methyl acrylate, ethyl acrylate, propyl acrylate, isopropyl acrylate, butyl acrylate, isobutyl acrylate, secondary butyl acrylate, t-butyl acrylate, pentyl acrylate, neopentyl acrylate, hexyl acrylate, heptyl acrylate, octyl acrylate, isooctyl acrylate, 2-ethylhexyl acrylate, decyl acrylate, isodecyl acrylate, lauryl acrylate, bornyl acrylate, isobornyl acrylate, myristyl acrylate, pentadecyl acrylate, stearyl acrylate and the like; methacrylic acid ester monomers, including methyl methacrylate, ethyl methacrylate, propyl methacrylate, isopropyl methacrylate, butyl methacrylate, isobutyl methacrylate, hexyl methacrylate, octyl methacrylate, isooctyl methacrylate, decyl methacrylate, isodecyl methacrylate, lauryl methacrylate, bornyl methacrylate, isobornyl methacrylate, myristyl methacrylate, pentadecyl methacrylate, stearyl methacrylate and the like; acrylic acid, methacrylic acid, itaconic acid, maleic acid, fumaric acid, styrene, substituted styrenes, butadiene, acrylonitrile, ethylene, vinyl acetate, and the like may be used. When styrene and substituted styrenes monomers are incorporated into the polymer they should be used at levels less than about 12% by weight of the total monomer weight.

The latex polymer particle size should be relatively small, between about 70 nanometers (nm) to about 225 nm, preferably from about 70 nm to about 120 nm. As is well-known, given the same polymer backbone, particle size is controlled primarily by the type and level of the emulsifier used.

The latex polymer emulsion should have a level of solids from about 30% to about 50%, preferably from about 35% to about 50%.

The multifunctional (meth)acrylates may be used alone or in combination. The molecular weight per one (meth)acryloyl group is less than about 1000, preferably from about 95 to about 300, and more preferably from about 95 to about 150.

Suitable multifunctional (meth)acrylates include polyfunctional (meth)acrylates obtained by reaction of a (meth)acryloxy-containing compound, such as (meth)acrylic acid, (meth)acryloyl halide, or a (meth)acrylic acid ester, with various compounds, such as hydroxy-containing alkyd resins, polyester condensates, or polyether-condensates. These complex (meth)acrylated products may in some instances be termed "polymeric", since the (meth)acryloxy groups may be joined to a condensation polymer, e.g. a polyester or a polyurethane, to an addition polymer, e.g., a polyether, or to a vinyl addition polymer, e.g. a glycidyl (meth)acrylate polymer.

Typical examples include: (A) Urethane (meth)acrylates obtained by reacting isocyanate groups of a polyisocyanate, such as hexamethylene diisocyanate with a hydroxyalkyl (meth)acrylate, e.g. hydroxyethyl (meth)acrylate. These polyurethane poly(meth)acrylate monomers are disclosed in US-A-3,297,745; (B) Polyether (meth)acrylates obtained by esterification of hydroxy-terminated polyethers with (meth)acrylic acid as disclosed in US-A-3,380,831; (C) Polyesters having at least two (meth)acrylate groups obtained by esterifying hydroxyl groups with (meth)acrylic acid as disclosed in US-A-3,935,173; (D) Multifunctional (meth)acrylates disclosed in US-A-3,560,237, e.g. obtained by reaction of a hydroxyalkyl (meth)acrylate, e.g. hydroxyethyl (meth)acrylate, with any one of: (a) Dicarboxylic acids having from 4 to 15 carbon atoms, (b) Polyepoxides having terminal glycidyl groups, (c) Polyisocyanates having terminal reactive isocyanate groups; (E) (Meth)acrylate-terminated polyesters made from (meth)acrylic acid, a polyol having at least three hydroxyl groups, and a dicarboxylic acid as disclosed in US-A-3,567,494; (F) Multifunctional (meth)acrylates obtained by the reaction of (meth)acrylic acid with at least two epoxy groups of epoxidized drying oils, such as soybean oil, linseed oil, and the like, e.g. epoxidized corresponding drying oil fatty acid, an ester or amide thereof, or the corresponding alcohol, containing at least 2 epoxy groups. Such multifunctional (meth)acrylates are disclosed in US-A-3,125,592; (G) Multifunctional (meth)acrylates which are urethane or amine derivatives of the poly(meth)acrylated epoxidized drying oils, fatty acids and the like described in (F) and U.S. Patent mentioned therein, obtained by the reaction of isocyanate(s) or amine(s) respectively with the poly(meth)acrylated epoxidized drying oils, fatty acids, and the like described in US-A-3,125,592. The urethane and amine derivatives retain some or all of the (meth)acrylate groups and are disclosed in US-A-3,876,518 and US-A-3,878,077; (H) Multifunctional (meth)acrylates obtained by reaction of (meth)acrylic acid by addition to the epoxy groups of aromatic bisphenol-based epoxy resins as disclosed in US-A-3,373,075; (I) Multifunctional (meth)acrylates obtained by the addition of (meth)acrylic acid to a linear vinyl polymer having pendant glycidyl groups, e.g. polymers of glycidyl (meth)acrylate or of vinyl glycidyl ether or vinyl glycidyl sulfide as disclosed in US-A-3,530,100; (J) Multifunctional (meth)acrylates derived from (meth)acrylic acid anhydride and polyepoxides as disclosed in US-A-3,676,398; (K) Multifunctional (meth)acrylate urethane esters obtained from the combining of hydroxyalkyl (meth)acrylates, a diisocyanate, and a hydroxyl functional alkyd condensate as disclosed in US-A-3,673,140; (L) (Meth)acrylate terminated urethane polyesters obtained by reaction of a polycaprolactone diol or triol with an organic polyisocyanate, e.g. a diisocyanate, and a hydroxyalkyl (meth)acrylate. Such products are disclosed in US-A-3,700,643; and (M) Urethane multifunctional (meth)acrylates obtained by reaction of a hydroxyl-containing ester of a polyol with (meth)acrylic acid and a polyisocyanate, such as those described in US-A-3,759,809.

The disclosure in the each of aforementioned documents (i.e. in each of the references in the statements labelled (A) through (M)) is incorporated herein by reference insofar as they disclose the multifunctional (meth)acryloxy-containing compounds and the processes of making them.

Preferred multifunctional (meth)acrylates are trimethylolpropane triacrylate and trimethylolpropane trimethacrylate, with trimethylolpropane triacrylate more preferred.

The weight ratio of the latex polymer to the multifunctional (meth)acrylate is from about 30:70 to about 95:5, preferably from about 40:60 to about 60:40, and most preferably from about 75:25 to about 65:35.

The formulated coating composition may be formed either by directly mixing the latex polymer emulsion and the multifunctional (meth)acrylate or by first pre-emulsifying the multifunctional (meth)acrylate and then mixing this with the latex polymer emulsion. The multifunctional (meth)acrylate can be made into an oil-in-water emulsion by adding a surfactant at a level from about 2% to about 5%.

Suitable anionic surfactants include, for example, the higher fatty alcohol sulfates, such as sodium lauryl sulfate, and the like; alkylaryl sulfonates such as sodium or potassium isopropylbenzene sulfonates or isopropyl naphthalene sulfonates, and the like; alkali metal higher alkyl sulfosuccinates, such as sodium octyl sulfosuccinate, sodium N-methyl-N-palmitoyltaurate, sodium oleyl isothionate, and the like; and alkali metal salts of alkylarylpolyethoxyethanol sulfates or sulfonates, such as sodium tert-octylphenoxypolyethoxyethyl sulfate having 1 to 5 oxyethylene units, and the like.

Suitable nonionic surfactants include alkylphenoxypoly ethoxyethanols having alkyl groups of from about 7 to 18 carbons atoms and from about 6 to about 60 oxyethylene units, such as heptyl-phenoxypolyethoxyethanols, methyloctylphenoxypolyethoxy ethanols, and the like; polyethoxyethanol derivatives of methylene-linked alkyl phenol; sulfur-containing agents such as those made by condensing from about 6 to about 60 moles of ethylene oxide with nonyl mercaptan, dodecyl mercaptan, and the like, or with alkyl-thiophenols wherein the alkyl groups contain from 6 to 16 carbons atoms; ethylene oxide derivatives of long-chained carboxylic acids, such as lauric acid, myristic acid, palmitic acid, oleic acid, and the like, or mixtures of acids such as those found in tall oil containing from 6 to 60 oxyethylene units per molecule; analogous ethylene condensates of long-chained alcohols such as octyl, decyl, lauryl, or cetyl alcohols, ethylene oxide derivatives of etherified or esterified polyhydroxy compounds having a hydrophobic hydrocarbon chain, such as sorbitan monostearate containing from 6 to 60 oxyethylene units; also, ethylene oxide sections combined with one or more hydrophobic propylene oxide sections. Mixtures of alkyl benzenesulfonates and ethoxylated alkylphenols may be employed.

The composition may optionally contain a ultraviolet photoinitiator. The low amount of photoinitiator which can optionally be employed is an additional advantage of the present invention. The photoinitiator may be added to the composition from about 0.1 % by weight of total nonvolatiles to about 0.5% by weight of total nonvolatiles and more preferably from about 0.2% by weight of total nonvolatiles to about 0.3% by weight of total nonvolatiles. Useful photoinitiators include cleavage-type initiators, halogenated polynuclear ketones, such as chlorosulfonated benzanthones, chlorosulfonated fluorenones, a-haloalkylated benzanthrones, and a-haloalkylated fluorenone as disclosed in US-A-3,827,957 and US-A-3,827,959; benzoin, its ethers, such as methyl ether, ethyl ether, isopropyl ether, butyl ether, octyl ether and the like; carbonyl compounds such as diacetyl, benzil and the like; sulfur compounds such diphenyl sulfide, dithiocarbamate and the like; a-chloromethyl naphthalene and anthracene. Other useful photoinitiators include alkylphenones and benzophenones as disclosed in US-A-3,759,807. Photoinitiators suitable for pigmented coatings are suggested in US-A-3,915,824 and US-A-3,847,771. Cleavage-type photoinitiators are most preferred.

The composition may contain a thermal initiator if the coating will be cured by heat or a catalyst if the coating will be cured by auto-oxidation. The thermal initiator is added to the composition from about 0.5% by weight of total nonvolatiles to about 2% by weight of total nonvolatiles. Useful thermal initiators include azo compounds, such as azobisisobutyronitrile and the like; organic peroxides, such as ketone peroxides, hydroperoxides, alkyl peroxides, acryl peroxides, peroxy esters and the like; and inorganic peroxides, such as ammonium persulfate, potassium persulfate, hydrogen peroxide and the like. Useful catalysts for auto-oxidative cure include the salts of cobalt, such as cobalt acetate, cobalt naphthenate and the like.

In addition, conventional coating components such as, for example, pigments, dispersants, surfactants, coalescents, wetting agents, rheology modifiers, thickeners, drying retarders, antifoaming agents, colorants, waxes, preservatives, heat stabilizers, ultraviolet light stabilizers and the like may be used in this invention.

Techniques for applying the UV-curable coating include roller coating, curtain coating, spraying and the like.

The formulated coating may be cured or crosslinked either by applying radiation or by heating after most or all of the water has evaporated from the mixture. Useful radiation includes ionizing radiation, electron beam radiation and ultraviolet radiation. Sources of ultraviolet radiation include sunlight, mercury lamp, carbon-arc lamp, xenon lamp and the like. Medium pressure mercury vapor lamps are preferred.

The UV-curable compositions may be used as topcoats, intermediate coats and primer coats. The compositions are useful in applications which require the reduced odor, toxicity and viscosity of aqueous-based, radiation-curable formulations, such as, for example, paints, including wood lacquers; adhesives; inks, including screen printing inks and gravure and flexographic printing inks; plastics, including vinyl sheeting and polyvinyl chloride flooring; fiber; paper, including overprint varnishes for paper and board; leather; solder mask photoresist on electronic circuit, printing plates and other composites using UV cure. The compositions are particularly useful in coating applications on wood, such as, for example, cabinets, furniture and flooring.

The present invention will now be illustrated by means of examples only.

**Example 1A. Preparation of Latex Polymer Emulsions**

For reference, Comparative Latex Polymer Emulsions 1C, 2C, 3C, 4C, 5C, 6C, 7C, 8C and Latex Polymer Emulsions 9, 10, 11, 12, 13, 14, 15, 16, 18, are one-stage polymers which were prepared by a redox gradual-addition emulsion polymerization process.

To a kettle, 1450 g of deionized water and 26.8 g of sodium lauryl sulfate (28%) ("SLS") were added. The kettle was heated to 59-61°C.

A Monomer Emulsion was prepared by mixing the appropriate monomers with deionized water and a 28% solution of sodium lauryl sulfate according to Table 1.1.

When the kettle temperature reached 59-61°C, 160 g of the Monomer Emulsion, 1.5 g of ammonium persulfate and 0.3 g of sodium bisulfite were added. After two minutes, a trace of ferric sulfate was added. The kettle charge exothermed to 67-69°C.

Fifteen minutes after the initiation, the cofeeds of the Monomer Emulsion, ammonium persulfate solution (1.6 g ammonium persulfate dissolved in 60 g of deionized water) and the sodium bisulfite solution (1.6 g sodium bisulfite dissolved in 60 g of deionized water) were begun. The Monomer Emulsion was added over 3 hours and the ammonium persulfate and sodium bisulfite feeds were added over the same time period with a 20 minute overfeed.

At the completion of the Monomer Emulsion feed, 40 g of deionized water were added twice in sequence. After all the feeds were completed, the kettle was held at 63°C for 20 minutes and then cooled to 55°C. Any unpolymerized monomers were then incorporated into the polymer by the stepwise addition of redox and thermal free radical initiators over twenty minutes followed by cooling to 35°C. When the kettle reached 35°C, a mixture of 14.3 g of ammonium hydroxide (28%) in 25.7 g of deionized water and 0.2 g of Proxel® CRL preservative was added. (Proxel is a trade mark of       .) The kettle was further cooled to ambient temperature and was then filtered.

The final latex polymer emulsion was approximately 37.5% solids, had a mean particle size of 80 nm, a viscosity of 15 centipoises measured via a Brookfield viscometer and had a pH of 7.5. The mole percent acrylate and glass transition temperature as calculated via the Fox equation are shown in Table 1.2.

**Example 1B. Preparation of Latex Polymer Emulsion**

For reference, Latex Polymer Emulsion 17 is a conventional, one-stage polymer which was prepared by a two-step emulsion polymerization process.

A Monomer Emulsion was prepared by mixing the appropriate monomers with deionized water and a 28% solution of sodium lauryl sulfate according to Table 1.1.

A flask was equipped with a stirrer, an inert gas introduction tube, a reflux condenser and a thermometer. To the flask, 765 g of deionized water, 13.6 g of sodium lauryl sulfate (28%) ("SLS") and 591 g of the Monomer Emulsion were added. In addition, a trace of ferrous sulfate, 0.25 g of ammonium persulfate, 0.15 g sodium sulfoxylate formaldehyde, 0.15 g sodium hydrosulfite and 0.08 g of t-butyl hydroperoxide were added to the flask. The contents of the flask then rose to approximately 70°C. The contents of the flask were then cooled to 35°C with constant stirring. The remainder of the Monomer Emulsion was then added to the flask followed by the addition of 0.2 g of ammonium persulfate, 0.12 g of sodium sulfoxylate formaldehyde, 0.05 g of sodium hydrosulfite and 0.08 g t-butyl hydroperoxide. The contents of the flask then rose to approximately 70°C. Any unpolymerized monomers were then incorporated into the polymer by the stepwise addition of redox and thermal free radical initiators over twenty minutes followed by cooling to 35°C. When the kettle reached 35°C, a mixture of 14.3 g of ammonium hydroxide (28%) in 25.7 g of deionized water and 0.2 g of Proxel® CRL preservative was added (Proxel is a trade mark of       ). The kettle was further cooled to ambient temperature and was then filtered.

The final latex polymer emulsion was approximately 37.5% solids, had a mean particle size of 115 nm, a viscosity of 10 centipoises measured via a Brookfield viscometer and had a pH of 7.5. The mole percent acrylate and glass transition temperature as calculated via the Fox equation are shown in Table 1.2.

## Table 1.1 Monomer Emulsion

Note: All values are in grams

|  | 1C | 2C | 3C | 4C | 5C | 6C | 7C |
|---|---|---|---|---|---|---|---|
| Deionized water | 600 | 600 | 600 | 600 | 600 | 600 | 600 |
| SLS (28%) | 27 | 27 | 27 | 27 | 27 | 27 | 27 |
| Methyl methacrylate | 945 | 720 | 495 | 675 | 945 | 720 | 795 |
| Butyl methacrylate | -- | -- | -- | -- | -- | -- | -- |
| Methyl acrylate | -- | -- | 975 | 795 | -- | -- | -- |
| Ethyl acrylate | 525 | 750 | -- | -- | -- | -- | -- |
| Butyl acrylate | -- | -- | -- | -- | 525 | 750 | 690 |
| Acrylic acid | 30 | 30 | 30 | 30 | 30 | 30 | -- |
| Methacrylic acid | -- | -- | -- | -- | -- | -- | 15 |
| Itaconic acid | -- | -- | -- | -- | -- | -- | -- |

|  | 8C | 9 | 10 | 11 | 12 | 13 | 14 |
|---|---|---|---|---|---|---|---|
| Deionized water | 600 | 600 | 600 | 600 | 600 | 600 | 600 |
| SLS (28%) | 27 | 27 | 27 | 27 | 27 | 27 | 27 |
| Methyl methacrylate | -- | 495 | 270 | -- | 371 | 278 | 183 |
| Butyl methacrylate | 990 | -- | -- | 495 | -- | -- | -- |
| Methyl acrylate | 495 | -- | -- | 990 | 300 | 600 | 900 |
| Ethyl acrylate | -- | 975 | 1200 | -- | 471 | 351 | 232 |
| Butyl acrylate | -- | -- | -- | -- | 343 | 256 | 170 |
| Acrylic acid | 15 | 30 | 30 | 15 | -- | -- | -- |
| Methacrylic acid | -- | -- | -- | -- | -- | -- | -- |
| Itaconic acid | -- | -- | -- | -- | 15 | 15 | 15 |

## Table 1.1  Monomer Emulsion (continued)

|  | 15 | 16 | 17 | 18 |
|---|---|---|---|---|
| Deionized water | 600 | 600 | 410 | 600 |
| SLS (28%) | 27 | 27 | 13.6 | 27 |
| Aerosol A103 (33%) | – | – | 5.7 | – |
| Methyl methacrylate | 88 | – | – | 450 |
| Butyl methacrylate | – | – | – | – |
| Methyl acrylate | 1200 | 1485 | 742 | – |
| Ethyl acrylate | 110 | – | – | 585 |
| Butyl acrylate | 82 | – | – | 435 |
| Acrylic acid | – | – | – | – |
| Methacrylic acid | – | – | – | – |
| Itaconic acid | 15 | 15 | 7.5 | 15 |

## Table 1.2  Properties of Latex Polymer Emulsions

| Latex Polymer Emulsion | Mole % Acrylate | Tg (°C) |
|---|---|---|
| 1C | 38 | 48 |
| 2C | 52 | 29 |
| 3C | 67 | 36 |
| 4C | 59 | 46 |
| 5C | 32 | 28 |
| 6C | 47 | 4 |
| 7C | 39 | 12 |
| 8C | 46 | 17 |
| 9 | 67 | 11 |
| 10 | 82 | -10 |
| 11 | 78 | 13 |
| 12 | 74 | -2 |
| 13 | 81 | 1 |
| 14 | 88 | 3 |
| 15 | 94 | 6 |
| 16 | 100 | 9 |
| 17 | 99 | 9 |
| 18 | 68 | -5 |

**Example 2. Preparation of Formulated Coating Composition**

2.1 Pre-emulsification of Multifunctional (Meth)acrylate

A 1.2 liter metal bucket with a 12.5 centimeter inside diameter was equipped with a dispersator with a 6.7 centimeter Cowles serrated blade. In the bucket, 8.6 g of nonionic surfactant (Triton® X-15) and 2.2 g of nonionic surfactant (Triton® X-102) were added to 125.8 g of deionized water. 360 g of trimethylolpropane triacrylate ("TMPTA") (Sartomer® 351) or 360 g of trimethylolpropane tri(meth)acrylate ("TMPTMA") (Sartomer® 350) were added over a 20 minute period using a 3 milliliter plastic dropper with the dispersator initially at 1000-1200 rpm and increasing the stirring to 2000 rpm as foaming allowed. After the addition of the trimethylolpropane tri(meth)acrylate, the stirring was increased to 3000 rpm for 10 minutes. (Triton is a trade mark of and Sartomer is a trade mark of          ).

2.2 Preparation of Formulation

For reference, see Table 2.1 for amount of each ingredient.

In a 2 liter metal bottle with a 5 centimeter stirrer, the photoinitiator (Darocur® 1173) was added to the latex polymer emulsion. The pre-emulsified multifunctional (meth)acrylate (72.5%) was then added dropwise from a 3 milliliter plastic dropper over a 15 minute period stirring to just maintain a small surface vortex. After the complete addition of the multifunctional (meth)acrylate, the mixture was stirred for an additional 30 minutes. The deionized water charge was added. An associative thickener solution (Acrysol® QR-708 -- 2% solids in water) was added to the mixture adjusting the stirring to keep a small surface vortex. The mixture was stirred for an additional 15 minutes. The mixture was equilibrated for at least 16 hours before use. The viscosity of the formulation was approximately 90 centipoise as measured by a Brookfield viscometer. (Darocur is a trade mark of            and Acrysol is a trade mark of            .)

## Table 2.1  Preparation of Coating Formulation

NOTE:        All values in grams.

The following designations signify the ratio of the polymer emulsion to the multifunctional  (meth)acrylate:

| | | | |
|---|---|---|---|
| -A | 80:20 | Polymer:TMPTA |
| -B | 70:30 | Polymer:TMPTA |
| -C | 60:40 | Polymer:TMPTA |
| -D | 70:30 | Polymer:TMPTMA |

| Latex Polymer Emulsion | Sartomer® 351 Preemulsion | Sartomer® 350 Preemulsion | Darocur® 1173 | Acrysol® QR-708 | DI $H_2O$ Charge | |
|---|---|---|---|---|---|---|
| ---------------------------Formulation  1C--------------------------- | | | | | | |
| 1C-A | 34.03 | 4.40 | — | 0.03 | 0.80 | 0.74 |
| 1C-B | 29.78 | 6.60 | — | 0.03 | 0.80 | 2.79 |
| 1C-C | 25.52 | 8.80 | — | 0.03 | 0.80 | 4.84 |
| 1C-D | 29.78 | — | 6.60 | 0.03 | 0.80 | 2.79 |
| ---------------------------Formulation  2C--------------------------- | | | | | | |
| 2C-A | 33.94 | 4.40 | — | 0.03 | 0.80 | 0.83 |
| 2C-B | 29.70 | 6.60 | — | 0.03 | 0.80 | 2.87 |
| 2C-C | 25.46 | 8.80 | — | 0.03 | 0.80 | 4.91 |
| 2C-D | 29.70 | — | 6.60 | 0.03 | 0.80 | 2.87 |
| ---------------------------Formulation  3C--------------------------- | | | | | | |
| 3C-A | 33.85 | 4.40 | — | 0.03 | 0.80 | 0.92 |
| 3C-B | 29.62 | 6.60 | — | 0.03 | 0.80 | 2.95 |
| 3C-C | 25.39 | 8.80 | — | 0.03 | 0.80 | 4.89 |
| 3C-D | 29.62 | — | 6.60 | 0.03 | 0.80 | 2.95 |
| ---------------------------Formulation  4C--------------------------- | | | | | | |
| 4C-A | 33.85 | 4.40 | — | 0.03 | 0.80 | 0.92 |
| 4C-B | 29.62 | 6.60 | — | 0.03 | 0.80 | 2.95 |
| 4C-C | 25.39 | 8.80 | — | 0.03 | 0.80 | 4.89 |
| 4C-D | 29.62 | — | 6.60 | 0.03 | 0.80 | 2.95 |

## Table 2.1 Preparation of Coating Formulation (continued)

| Latex Polymer Emulsion | Sartomer® 351 Preemulsion | Sartomer® 350 Preemulsion | Darocur® 1173 | Acrysol® QR-708 | DI H$_2$O Charge | |
|---|---|---|---|---|---|---|
| ----------------------Formulation 5C---------------------------- | | | | | | |
| 5C-A | 34.40 | 4.40 | – | 0.03 | 0.80 | 0.37 |
| 5C-B | 30.10 | 6.60 | – | 0.03 | 0.80 | 2.47 |
| 5C-C | 25.80 | 8.80 | – | 0.03 | 0.80 | 4.57 |
| 5C-D | 30.10 | – | 6.60 | 0.03 | 0.80 | 2.47 |
| ----------------------Formulation 6C---------------------------- | | | | | | |
| 6C-A | 34.12 | 4.40 | – | 0.03 | 0.80 | 0.65 |
| 6C-B | 29.86 | 6.60 | – | 0.03 | 0.80 | 2.71 |
| 6C-C | 25.59 | 8.80 | – | 0.03 | 0.80 | 4.78 |
| 6C-D | 29.86 | – | 6.60 | 0.03 | 0.80 | 2.71 |
| ----------------------Formulation 7C---------------------------- | | | | | | |
| 7C-A | 33.15 | 4.40 | – | 0.03 | 0.80 | 1.62 |
| 7C-B | 29.00 | 6.60 | – | 0.03 | 0.80 | 3.56 |
| 7C-C | 24.86 | 8.80 | – | 0.03 | 0.80 | 5.51 |
| 7C-D | 29.00 | – | 6.60 | 0.03 | 0.80 | 3.56 |
| ----------------------Formulation 8---------------------------- | | | | | | |
| 8C-A | 33.15 | 4.40 | – | 0.03 | 0.80 | 1.62 |
| 8C-B | 29.00 | 6.60 | – | 0.03 | 0.80 | 3.56 |
| 8C-C | 24.86 | 8.80 | – | 0.03 | 0.80 | 5.51 |
| 8C-D | 29.00 | – | 6.60 | 0.03 | 0.80 | 3.56 |
| ----------------------Formulation 9---------------------------- | | | | | | |
| 9-A | 34.12 | 4.40 | – | 0.03 | 0.80 | 0.65 |
| 9-B | 29.86 | 6.60 | – | 0.03 | 0.80 | 2.71 |
| 9-C | 25.59 | 8.80 | – | 0.03 | 0.80 | 4.78 |
| 9-D | 29.86 | – | 6.60 | 0.03 | 0.80 | 2.71 |

## Table 2.1 Preparation of Coating Formulation (continued)

| Latex Polymer Emulsion | Sartomer® 351 Preemulsion | Sartomer® 350 Preemulsion | Darocur® 1173 | Acrysol® QR-708 | DI H$_2$O Charge | |
|---|---|---|---|---|---|---|
| ----------------------------Formulation 10---------------------------- | | | | | | |
| 10-A | 33.76 | 4.40 | — | 0.03 | 0.80 | 1.01 |
| 10-B | 29.54 | 6.60 | — | 0.03 | 0.80 | 3.03 |
| 10-C | 25.32 | 8.80 | — | 0.03 | 0.80 | 5.05 |
| 10-D | 29.54 | — | 6.60 | 0.03 | 0.80 | 3.03 |
| ----------------------------Formulation 11---------------------------- | | | | | | |
| 11-A | 33.23 | 4.40 | — | 0.03 | 0.80 | 1.53 |
| 11-B | 29.08 | 6.60 | — | 0.03 | 0.80 | 3.49 |
| 11-C | 24.93 | 8.80 | — | 0.03 | 0.80 | 5.44 |
| 11-D | 29.08 | — | 6.60 | 0.03 | 0.80 | 3.49 |
| ----------------------------Formulation 12---------------------------- | | | | | | |
| 12-A | 33.15 | 4.40 | — | 0.03 | 0.80 | 1.62 |
| 12-B | 29.00 | 6.60 | — | 0.03 | 0.80 | 3.56 |
| 12-C | 24.86 | 8.80 | — | 0.03 | 0.80 | 5.51 |
| 12-D | 29.00 | — | 6.60 | 0.03 | 0.80 | 3.56 |
| ----------------------------Formulation 13---------------------------- | | | | | | |
| 13-A | 33.06 | 4.40 | — | 0.03 | 0.80 | 1.62 |
| 13-B | 29.00 | 6.60 | — | 0.03 | 0.80 | 3.56 |
| 13-C | 24.86 | 8.80 | — | 0.03 | 0.80 | 5.51 |
| 13-D | 29.00 | — | 6.60 | 0.03 | 0.80 | 3.56 |
| ----------------------------Formulation 14---------------------------- | | | | | | |
| 14-A | 33.15 | 4.40 | — | 0.03 | 0.80 | 1.62 |
| 14-B | 29.00 | 6.60 | — | 0.03 | 0.80 | 3.56 |
| 14-C | 24.86 | 8.80 | — | 0.03 | 0.80 | 5.51 |
| 14-D | 29.00 | — | 6.60 | 0.03 | 0.80 | 3.56 |

## Table 2.1  Preparation of Coating Formulation (continued)

| Latex Polymer Emulsion | Sartomer® 351 Preemulsion | Sartomer® 350 Preemulsion | Darocur® 1173 | Acrysol® QR-708 | DI $H_2O$ Charge | |
|---|---|---|---|---|---|---|
| -----------------------------Formulation  15----------------------------- | | | | | | |
| 15-A | 33.15 | 4.40 | — | 0.03 | 0.80 | 1.62 |
| 15-B | 29.00 | 6.60 | — | 0.03 | 0.80 | 3.56 |
| 15-C | 24.86 | 8.80 | — | 0.03 | 0.80 | 5.51 |
| 15-D | 29.00 | — | 6.60 | 0.03 | 0.80 | 3.56 |
| -----------------------------Formulation  16----------------------------- | | | | | | |
| 16-A | 33.23 | 4.40 | — | 0.03 | 0.80 | 1.53 |
| 16-B | 29.08 | 6.60 | — | 0.03 | 0.80 | 3.49 |
| 16-C | 24.93 | 8.80 | — | 0.03 | 0.80 | 5.44 |
| 16-D | 29.08 | — | 6.60 | 0.03 | 0.80 | 3.49 |
| -----------------------------Formulation  17----------------------------- | | | | | | |
| 17-A | 34.12 | 4.40 | — | 0.03 | 0.80 | 0.65 |
| 17-B | 29.86 | 6.60 | — | 0.03 | 0.80 | 2.71 |
| 17-C | 25.59 | 8.80 | — | 0.03 | 0.80 | 4.78 |
| 17-D | 29.86 | — | 6.60 | 0.03 | 0.80 | 2.71 |
| -----------------------------Formulation  18----------------------------- | | | | | | |
| 18-A | 33.15 | 4.40 | — | 0.03 | 0.80 | 1.62 |
| 18-B | 29.00 | 6.60 | — | 0.03 | 0.80 | 3.56 |
| 18-C | 24.86 | 8.80 | — | 0.03 | 0.80 | 5.51 |

**Example 3. Preparation of Coated Specimens**

The formulated coating was applied to a phosphatized steel panel using a wet film applicator with a 0.127mm (5 mil) gate. The coating was allowed to dry for 15 minutes at room temperature and then for 10 minutes at 65.5°C (150°F) in a forced air oven. The coated panel was then cured with one pass through an RPC Model 1202 UV processor equipped with two 7.87 watts/mm (200 watts/inch) medium pressure mercury arc lamps at a belt speed of 0.102 ms$^{-1}$ (20 feet/minute) (approximately 2 Joules/cm$^2$ total energy). The final dried coating thickness was about 0.0254mm (1 mil).

**Example 4. Direct Impact Testing**

For this study, each steel panel was coated and cured then tested for direct impact strength with a Gardner falling weight impact tester Model #1G1120. Also, each cured coated test specimen was placed with the coated side facing up on a die at the base of a guide tube which served as the track for a weighted falling indenter. The weighted indenter was raised to a specific height and released. Each coating was then inspected after impact. If the coating did not fracture, the test was again repeated of a new area of the same specimen by releasing the impacter at a higher elevation. If the coating did fracture, a new test specimen was tested at a lower elevation. Each test specimen was rated as the minimum inch-pounds of force required to fracture the coating. The results are reported in Table 4.1. Coatings with direct impact strengths greater than 2.3 Joules (20 inch-pounds) perform well on wood substrates, with direct impact strengths greater than 3.4 Joules (30 inch-pounds) particularly preferred.

13

## Table 4.1  Direct Impact Test Results

| Coating Formulation | Minimum to Fracture | |
|---|---|---|
| | Joules | (Inch-Pounds) |
| 1C-A | 1.6-1.7 | (14-15) |
| 1C-B | 1.1-1.2 | (10-11) |
| 1C-C | 1.4-1.5 | (12-13) |
| 1C-D | 0.9-1 | ( 8-9) |
| 2C-A | 1.6-1.7 | (14-15) |
| 2C-B | 1.4-1.5 | (12-13) |
| 2C-C | 2-2.1 | (18-19) |
| 2C-D | 0.7-0.8 | ( 6-7) |
| 3C-A | 1.4-1.5 | (12-13) |
| 3C-B | 1.1-1.2 | (10-11) |
| 3C-C | 2-2.1 | (18-19) |
| 3C-D | 0.9-1 | ( 8-9) |
| 4C-A | (--) | -- |
| 4C-B | 0.9-1 | (8-9) |
| 4C-C | 0.9-1 | (8-9) |
| 4C-D | 1.4-1.5 | (12-13) |
| 5C-A | 1.1-1.2 | (10-11) |
| 5C-B | 1.1-1.2 | (10-11) |
| 5C-C | 2-2.1 | (18-19) |
| 5C-D | 0.9-1 | (8-9) |

## Table 4.1  Direct Impact Test Results (continued)

| Coating Formulation | Minimum to Fracture Joules (Inch-Pounds) | |
|---|---|---|
| 6C-A | 4.1-4.2 | (36-37) |
| 6C-B | 2.7-2.8 | (24-25) |
| 6C-C | 2.5-2.6 | (22-23) |
| 6C-D | 0.9-1 | (8-9) |
| 7C-A | 1.4-1.5 | (12-13) |
| 7C-B | 2.3-2.4 | (20-21) |
| 7C-C | 2-2.1 | (18-19) |
| 7C-D | 0.9-1 | (8-9) |
| 8C-A | >5.7 | (>50) |
| 8C-B | >5.7 | (>50) |
| 8C-C | 3.2-3.3 | (28-29) |
| 8C-D | 1.8-1.9 | (16-17) |
| 9-A | >5.7 | (>50) |
| 9-B | >5.7 | (>50) |
| 9-C | 3.4-3.5 | (30-31) |
| 9-D | 2-2.1 | (18-19) |
| 10-A | >5.7 | (>50) |
| 10-B | >5.7 | (>50) |
| 10-C | 2.9-3.1 | (26-27) |
| 10-D | >5.7 | (>50) |

## Table 4.1  Direct Impact Test Results (continued)

| Coating Formulation | Minimum to Fracture | |
|---|---|---|
| | Joules | (Inch-Pounds) |
| 11-A | 5.4-5.5 | (48-49) |
| 11-B | 5.4-5.5 | (48-49) |
| 11-C | 3.2-3.3 | (28-29) |
| 11-D | 3.8-4.0 | (34-35) |
| 12-A | 5.4-5.5 | (48-49) |
| 12-B | >5.7 | (>50) |
| 12-C | 3.2-3.3 | (28-29) |
| 12-D | >5.7 | (>50) |
| 13-A | >5.7 | (>50) |
| 13-B | 5.4-5.5 | (48-49) |
| 13-C | 2.9-3.1 | (26-27) |
| 13-D | >5.7 | (>50) |
| 14-A | >5.7 | (>50) |
| 14-B | >5.7 | (>50) |
| 14-C | 4.5-4.6 | (40-41) |
| 14-D | >5.7 | (>50) |
| 15-A | >5.7 | (>50) |
| 15-B | 5.4-5.5 | (48-49) |
| 15-C | 3.2-3.3 | (28-29) |
| 15-D | 4.5-4.6 | (40-41) |

## Table 4.1 Direct Impact Test Results (continued)

| Coating Formulation | Minimum to Fracture Joules (Inch-Pounds) | |
|---|---|---|
| 16-A | >5.7 | (>50) |
| 16-B | 3.6-3.7 | (32-33) |
| 16-C | (-) | (—) |
| 16-D | 1.8-1.9 | (16-17) |
| 17-A | >5.7 | (>50) |
| 17-B | 5.4-5.5 | (48-49) |
| 17-C | 3.4-3.5 | (30-31) |
| 17-D | 3.6-3.7 | (32-33) |
| 18-A | >5.7 | (>50) |
| 18-B | 5.2-5.3 | (46-47) |
| 18-C | 3.2.-3.3 | (28-29) |

**Example 5. Print Resistance Testing**

For this study, each steel panel was coated and cured and then tested for print resistance. A piece of cheesecloth was placed over the coated side of the steel panel and held at 65.5°C (150°) for 4 hours at 2812.3 kgm$^{-2}$ (4 pounds/square inch pressure). The coating was rated on a scale from 0-5 where 0=no print, 1=25% of pattern visible, 2=50% of pattern visible, 3=75% of pattern visible, 4=100% of pattern visible, 5-difficult to remove cloth. The results are reported in Table 5.1. Coatings with print resistance ratings less than or equal to 2 perform satisfactorily.

## Table 5.1 Print Resistance Test Results

| Coating Formulation | Print Resistance Rating |
| --- | --- |
| 1C-A | 3 |
| 1C-B | 2 |
| 1C-C | 1 |
| 1C-D | 2 |
| 2C-A | 3 |
| 2C-B | 2 |
| 2C-C | 1 |
| 2C-D | 1 |
| 3C-A | 1 |
| 3C-B | 1 |
| 3C-C | 1 |
| 3C-D | 0.5 |
| 4C-A | 3 |
| 4C-B | 2 |
| 4C-C | 1 |
| 4C-D | 2 |
| 5C-A | 3 |
| 5C-B | 1 |
| 5C-C | 1 |
| 5C-D | 1 |

## Table 5.1  Print Resistance Test Results (continued)

| Coating Formulation | Print Resistance Rating |
| --- | --- |
| 6C-A | 3 |
| 6C-B | 2 |
| 6C-C | 1 |
| 6C-D | 1 |
| 7C-A | 3 |
| 7C-B | 1 |
| 7C-C | 0.5 |
| 7C-D | 0.5 |
| 8C-A | 2 |
| 8C-B | 1 |
| 8C-C | 0.5 |
| 8C-D | 1 |
| 9-A | 2 |
| 9-B | 1 |
| 9-C | 0.5 |
| 9-D | 5 |
| 10-A | 2 |
| 10-B | 0.5 |
| 10-C | 0 |
| 10-D | 0.5 |

## Table 5.1  Print Resistance Test Results (continued)

| Coating Formulation | Print Resistance Rating |
| --- | --- |
| 11-A | 2 |
| 11-B | 1 |
| 11-C | 0.5 |
| 11-D | 0.5 |
| | |
| 12-A | 3 |
| 12-B | 1 |
| 12-C | 0.5 |
| 12-D | 0.5 |
| | |
| 13-A | 3 |
| 13-B | 1 |
| 13-C | 0 |
| 13-D | 0.5 |
| | |
| 14-A | 3 |
| 14-B | 1 |
| 14-C | 0.5 |
| 14-D | 1 |
| | |
| 15-A | 1 |
| 15-B | 0.5 |
| 15-C | 0 |
| 15-D | 0 |

## Table 5.1 Print Resistance Test Results (continued)

| Coating Formulation | Print Resistance Rating |
|---|---|
| 16-A | 1 |
| 16-B | 1 |
| 16-C | 0.5 |
| 16-D | 0 |
| 17-A | 1 |
| 17-B | 1 |
| 17-C | 0 |
| 17-D | 0 |
| 18-A | 2 |
| 18-B | 0.5 |
| 18-C | 0 |

**Example 6. Mar Resistance Testing**

For this study, each steel panel which was coated and cured and then tested for mar resistance by striking the coating vigorously several times with the back of a fingernail. The coating was rated on a scale from 0 to 5 with 5=no mark. The results are reported in Table 6.1. Coatings with mar resistance ratings greater than or equal to 4 perform satisfactorily.

## Table 6.1 Mar Resistance Test Results

| Coating Formulation | Mar Resistance Rating |
|---|---|
| 1C-A | 3 |
| 1C-B | 4 |
| 1C-C | 4 |
| 1C-D | 4 |
| 2C-A | 3 |
| 2C-B | 4 |
| 2C-C | 5 |
| 2C-D | 5 |
| 3C-A | 4 |
| 3C-B | 5 |
| 3C-C | 5 |
| 3C-D | 5 |
| 4C-A | 4 |
| 4C-B | 5 |
| 4C-C | 5 |
| 4C-D | 5 |
| 5C-A | 3 |
| 5C-B | 4 |
| 5C-C | 5 |
| 5C-D | 4 |

## Table 6.1 Mar Resistance Test Results (continued)

| Coating Formulation | Mar Resistance Rating |
|---|---|
| 6C-A | 3 |
| 6C-B | 3 |
| 6C-C | 4 |
| 6C-D | 4 |
| 7C-A | 3 |
| 7C-B | 5 |
| 7C-C | 5 |
| 7C-D | 5 |
| 8C-A | 4 |
| 8C-B | 4+ |
| 8C-C | 5 |
| 8C-D | 5 |
| 9-A | 4 |
| 9-B | 4 |
| 9-C | 5 |
| 9-D | 5 |
| 10-A | 5 |
| 10-B | 5 |
| 10-C | 5 |
| 10-D | 5 |

## Table 6.1 Mar Resistance Test Results (continued)

| Coating Formulation | Mar Resistance Rating |
| --- | --- |
| 11-A | 5 |
| 11-B | 5 |
| 11-C | 5 |
| 11-D | 4 |
| 12-A | 5 |
| 12-B | 5 |
| 12-C | 5 |
| 12-D | 4 |
| 13-A | 5 |
| 13-B | 5 |
| 13-C | 5 |
| 13-D | 5 |
| 14-A | 5 |
| 14-B | 5 |
| 14-C | 5 |
| 14-D | 5 |
| 15-A | 5 |
| 15-B | 5 |
| 15-C | 5 |
| 15-D | 5 |

## Table 6.1 Mar Resistance Test Results (continued)

| Coating Formulation | Mar Resistance Rating |
|---|---|
| 16-A | 4+ |
| 16-B | 4+ |
| 16-C | 4+ |
| 16-D | 5 |
| 17-A | 4 |
| 17-B | 5 |
| 17-C | 5 |
| 17-D | 5 |
| 18-A | 4 |
| 18-B | 5 |
| 18-C | 5 |

**Example 7. Pencil Hardness Testing**

For this study, each steel panel was coated and cured and then tested for pencil hardness using a mechanical holder. Lead of varying hardness was flattened on the end and then pressed against the coating at a 45° angle until either the lead broke or a cut was made through the coating to the substrate. The coating hardness was rated by the hardest lead which did not tear the coating, according to the following chart in order of increasing hardness: 6B, 5B, 4B, 3B, 2B, B, HB, F, H, 2H, 3H, 4H, 5H, 6H, 7H, 8H. The results are reported in Table 7.1. Coatings with a pencil hardness greater than or equal to HB perform satisfactorily.

## Table 7.1  Pencil Hardness Results

| Coating Formulation | Pencil Hardness Rating |
| --- | --- |
| 1C-A | H |
| 1C-B | H |
| 1C-C | H |
| 1C-D | F |
| 2C-A | 2H |
| 2C-B | 2H |
| 2C-C | H |
| 2C-D | H |
| 3C-A | 2H |
| 3C-B | F |
| 3C-C | F |
| 3C-D | 2H |
| 4C-A | H |
| 4C-B | 2H |
| 4C-C | F |
| 4C-D | F |
| 5C-A | F |
| 5C-B | H |
| 5C-C | F |
| 5C-D | H |

## Table 7.1 Pencil Hardness Test Results (continued)

| Coating Formulation | Pencil Hardness Rating |
| --- | --- |
| 6C-A | H |
| 6C-B | 2H |
| 6C-C | F |
| 6C-D | H |
| 7C-A | F |
| 7C-B | F |
| 7C-C | F |
| 7C-D | 2H |
| 8C-A | F |
| 8C-B | F |
| 8C-C | F |
| 8C-D | F |
| 9-A | H |
| 9-B | F |
| 9-C | H |
| 9-D | H |
| 10-A | F |
| 10-B | F |
| 10-C | F |
| 10-D | F |

## Table 7.1  Pencil Hardness Test Results (continued)

| Coating Formulation | Pencil Hardness Rating |
| --- | --- |
| 11-A | F |
| 11-B | H |
| 11-C | B |
| 11-D | F |
| 12-A | F |
| 12-B | F |
| 12-C | F |
| 12-D | F |
| 13-A | F |
| 13-B | F |
| 13-C | 2H |
| 13-D | F |
| 14-A | F |
| 14-B | F |
| 14-C | H |
| 14-D | F |
| 15-A | F |
| 15-B | 2H |
| 15-C | 2H |
| 15-D | F |

### Table 7.1 Pencil Hardness Test Results (continued)

| Coating Formulation | Pencil Hardness Rating |
| --- | --- |
| 16-A | 2H |
| 16-B | 2H |
| 16-C | -- |
| 16-D | 2H |
| 17-A | H |
| 17-B | 2H |
| 17-C | 2H |
| 17-D | H |
| 18-A | F |
| 18-B | F |
| 18-C | 2H |

## Claims

1. A composition comprising a latex polymer emulsion and a multifunctional (meth)acrylate, wherein the latex polymer in the emulsion contains greater than about 47 mole percent acrylate and has a glass transition temperature less than about 28°C.

2. The composition of claim 1 wherein the latex polymer comprises monomers selected from the group consisting of acrylic esters, methacrylic esters, acrylic acid, methacrylic acid, itaconic acid, maleic acid, fumaric acid, butadiene, acrylonitrile, ethylene and vinyl acetate.

3. The composition of claim 2 wherein the latex polymer comprises methyl acrylate.

4. The composition of any one of the preceding claims wherein the latex polymer further comprises unsubsituted or subsituted styrene at a level of less than about 12% by weight.

5. The composition of any one of the preceding claims wherein the multifunctional (meth)acrylate is trimethylolpropane triacrylate or trimethylolpropane trimethacrylate.

6. The composition of any one of the preceding claims wherein the weight ratio of latex polymer to multifunctional (meth)acrylate is from about 30:70 to about 95:5.

7. The composition of claim 1 further comprising at least one of a photoinitiator, a thermal initiator and a catalyst for auto-oxidative cure.

8. Use of a coating composition as defined in any one of the preceding claims as a general purpose curable coating.

9. The use of claim 8 wherein the composition is used as a coating on wood, on plastic, on fiber, on paper, on leather, as a photoresist, in inks, in paint, or in an adhesive.

10. A cured polymer coating comprising a composition according to any one of claims 1 to 7.

**European Patent Office**

## EUROPEAN SEARCH REPORT

Application Number

EP    91 31 0472

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-2 076 863 (COMMISSARIAT A L' ENERGIE ATOMIQUE) * the whole document * | 1-10 | C08F265/04 C09D4/06 C08F265/06 |
| X | FR-A-2 278 726 (MITSUBISHI RAYON) *claims* | 1-10 | |
| X | EP-A-0 355 032 (NATIONAL STARCH AND CHEMICAL CORPORATION) *claims* | 1-10 | |
| | | | **TECHNICAL FIELDS SEARCHED (Int. Cl.5)** |
| | | | C08F C09D |

The present search report has been drawn up for all claims

| Place of search | Date of completion of the search | Examiner |
|---|---|---|
| THE HAGUE | 31 JANUARY 1992 | ANDRIOLLO G. R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)